# EUROPEAN PATENT APPLICATION

(11) **EP 4 839 055 A1**
(43) Date of publication of application: **11.11.2026**
(21) Application number: 26176497.1
(22) Date of filing: 05.05.2026
(51) Int. Cl.: H10F 55/25, F41H 13/00, H02M 3/156, H03K 17/78, H10F 77/50

(54) **COMPACT MULTI-COMPARTMENT PHOTOCONDUCTIVE SEMICONDUCTOR SWITCH ASSEMBLY WITH EMBEDDED LIGHT SOURCE FOR FAST HIGH-VOLTAGE HIGH-CURRENT APPLICATIONS**

(30) Priority: 05.05.2025 US 202563800351 P
(71) Applicant: Eureka Aerospace, Pasadena, CA 91107 (US)
(72) Inventor: Li, Jiaxin, Pasadena, 91107 (US); Minovich, Alexander E., Pasadena, 91107 (US); Tatoian, James Z., Pasadena, 91107 (US); Zutavern, Fred J., Pasadena, 91107 (US)
(74) Representative: Patentanwaltskanzlei Matschnig & Forsthuber OG

(57) **Abstract**

A photoconductive semiconductor switch (PCSS) assembly includes a PCSS compartment having a PCSS housing, a PCSS disposed within the housing, PCSS compartment contacts for providing power to the PCSS, a PCSS compartment window forming a bottom end of the housing, a PCSS lid forming a top end of the housing, and a focusing optical element (FOE) for focusing light beams onto the PCSS. The assembly further includes a light source (LS) compartment having an LS housing, a triggering LS, an LS housing window, and a collimating optical element (COE) disposed above the triggering LS to form collimated light beams. The PCSS compartment and LS compartment are immediately adjacent with at least the PCSS compartment hermetically sealed, and the collimated light beams pass through the COE, LS housing window, PCSS compartment window, and FOE before striking the PCSS.

## Description

### CROSS-REFERENCE TO RELATED APPLICATIONS

The present application claims benefit under 35 U.S.C. 119(e) to U.S. Provisional Patent Application No. 63/800,351, titled "Compact Multi-Compartment Photoconductive Semiconductor Switch Assembly with Embedded Light Source for Fast High-Voltage High-Current Applications", filed April 14, 2025, the disclosures of which are incorporated herein by reference in their entirety.

### FIELD OF THE INVENTION

This invention relates generally to electronic switching devices. More specifically, the invention relates to photoconductive semiconductor switch (PCSS) technology comprising a compact multi-compartment PCSS assembly with an embedded light source and is designed for high-voltage, high-current pulsed power applications requiring rapid switching with a fast rise time, wherein the device integrates a triggering light source, optical components, and a hermetically sealed PCSS compartment to enhance performance, durability, and reliability.

### BACKGROUND

Photoconductive semiconductor switches (PCSS) are electronic switching devices that utilize the photoconductive properties of semiconductor materials to enable high-voltage and high-current switching. A PCSS typically includes a photoconductive substrate with conductive contacts fabricated on its surface and separated by a gap. When an electrical potential difference is applied between the contacts without illumination, the substrate exhibits low electrical conductance and holds off high voltage. Upon illumination with light, free charge carriers are generated in the photoconductive substrate, causing the resistance to rapidly drop and enabling electric current to flow between the contacts. These properties make PCSS devices suitable for applications requiring fast rise times or slew rates.

Various approaches have been developed for triggering PCSS devices and managing current flow through the photoconductive substrate. Early PCSS devices operated in a linear mode where each absorbed photon generated a single pair of charge carriers, requiring high-energy optical pulses from large laser systems to achieve high current levels. The discovery of high-gain modes in certain semiconductor materials reduced the optical energy requirements for triggering. Different methods have been explored for structuring the illumination pattern on the PCSS surface, including the use of lens arrays, masking techniques, and arrangements of light emitters in periodic patterns. Additionally, various light sources have been considered for triggering PCSS devices, including solid-state laser systems, edge-emitting semiconductor lasers, and vertical-cavity surface-emitting laser (VCSEL) arrays.

### SUMMARY OF INVENTION

Systems and methods for multi-compartment photoconductive semiconductor switch (PCSS) assembly with embedded light source in accordance with embodiments of the invention are illustrated. One embodiment includes a PCSS assembly, the PCSS assembly includes a PCSS compartment, the PCSS compartment includes a PCSS housing, a PCSS disposed within the PCSS housing, and a set of PCSS compartment contacts for providing power to the PCSS. The PCSS compartment further includes a PCSS compartment window forming a bottom end of the PCSS housing, a PCSS lid forming a top end of the PCSS housing, and a focusing optical element (FOE) disposed within the PCSS housing for focusing light beams onto the PCSS. The PCSS assembly further includes a light source (LS) compartment including a LS housing, a triggering LS disposed at a bottom end of the LS housing, a LS housing window forming a top end of the LS housing, and a collimating optical element (COE) disposed above the triggering LS to form collimated light beams from the triggering LS. The PCSS compartment and the LS compartment are immediately adjacent to each other and at least the PCSS compartment is hermetically sealed, and the collimated light beams from the LS compartment pass through the COE, the LS housing window, the PCSS compartment window, and the FOE before striking the PCSS.

In another embodiment, the PCSS housing forms sidewalls, the set of PCSS compartment contacts partially forming opposite sidewalls of the PCSS housing and configured to provide an electrical connection between an external high voltage source and the PCSS, wherein the set of PCSS compartment contacts extend partially towards but are electrically isolated from each other, the PCSS disposed in contact with the set of PCSS compartment contacts and positioned across an upper portion of the PCSS housing, the FOE aligned parallel with and adjacent to the PCSS, and being disposed closer to the bottom end of the PCSS housing than the PCSS, and the LS is coupled to the PCSS and configured to induce photoconductivity in the PCSS to enable rapid switching.

In a further embodiment, the PCSS assembly further includes an optical inspection compartment disposed between the PCSS compartment and the LS compartment, wherein the optical inspection compartment includes a dichroic mirror configured to transmit the collimated light beams of a wavelength of the triggering LS from the LS compartment to the PCSS compartment while reflecting a portion of light from the PCSS for inspection.

In still another embodiment, the PCSS assembly further includes using a high-voltage insulation material in the PCSS assembly to withstand and isolate high-power electrical discharges (arcing) within the PCSS assembly.

In a still further embodiment, the PCSS compartment is filled with a dielectric fluid to increase hold-off voltage between the set of PCSS compartment contacts.

In yet another embodiment, the PCSS assembly further includes fluid connectors attached to the PCSS housing for injection, extraction, and circulation of the dielectric fluid.

In a yet further embodiment, the PCSS lid includes PCSS lid shrouds for attaching the PCSS lid to the PCSS housing and flexible PCSS pushers configured to press the PCSS against the set of PCSS compartment contacts.

In another additional embodiment, the FOE includes a microlens array configured to focus the collimated light beams into a periodic line pattern on a surface of the PCSS.

In a further additional embodiment, the PCSS assembly further includes a transmission line connected to the PCSS compartment.

In another embodiment again, multiple PCSS assemblies are arranged in a stack configuration to increase current handling capability.

In a further embodiment again, the triggering LS and the FOE are configured to project a periodic line pattern onto a surface of the PCSS to induce multiple current filaments, thereby enabling current sharing and increasing the total current handling capability of the PCSS.

In still yet another embodiment, the triggering LS includes a vertical-cavity surface-emitting laser (VCSEL) array at a predetermined wavelength.

In a still yet further embodiment, the COE is configured to transform light from the triggering LS into weakly divergent light beams, wherein a distance between the triggering LS and the COE deviates from a focal distance of the COE to produce the weakly divergent light beams, and the FOE is configured to focus the weakly divergent light beams onto a surface of the PCSS.

In still another additional embodiment, the set of PCSS compartment contacts include a precise spacer disposed between the FOE and the PCSS to maintain a precise distance between the FOE and PCSS.

In a still further additional embodiment, the precise spacer serves as conductive contact surfaces and provide an electrical connection to the set of PCSS compartment contacts.

In still another embodiment again, the PCSS includes a PCSS substrate, two intermediate contact areas fabricated on a surface of the PCSS substrate, and a set of conductive PCSS contacts fabricated on top of the intermediate contact areas.

One embodiment includes a PCSS assembly, the PCSS assembly includes a PCSS compartment. The PCSS compartment includes a PCSS housing, a PCSS disposed within the PCSS housing, a set of PCSS compartment contacts for providing power to the PCSS, a PCSS compartment window forming a bottom end of the PCSS housing, a PCSS lid forming a top end of the PCSS housing, and an FOE disposed within the PCSS housing for focusing light beams onto the PCSS. The PCSS assembly further includes an LS compartment. The LS compartment includes a LS housing, a triggering LS disposed at a bottom end of the LS housing, a LS housing window forming a top end of the LS housing, and a COE disposed above the triggering LS to form collimated light beams from the triggering LS. The PCSS compartment and the LS compartment are immediately adjacent to each other and at least the PCSS compartment is hermetically sealed, and the collimated light beams from the LS compartment pass through the COE, the LS housing window, the PCSS compartment window, and the FOE before striking the PCSS. The PCSS lid includes a set of PCSS lid shrouds for attaching the PCSS lid to the PCSS housing, and a set of flexible PCSS pushers configured to press the PCSS against the set of PCSS compartment contacts.

One embodiment includes a PCSS assembly, the PCSS assembly includes a PCSS compartment. The PCSS compartment includes a PCSS housing, a PCSS disposed within the PCSS housing, a set of PCSS compartment contacts for providing power to the PCSS, a PCSS compartment window forming a bottom end of the PCSS housing, a PCSS lid forming a top end of the PCSS housing, and an FOE disposed within the PCSS housing for focusing light beams onto the PCSS. The PCSS assembly further includes a PCSS substrate, two intermediate contact areas fabricated on a surface of the PCSS substrate, and a set of conductive PCSS contacts fabricated on top of the intermediate contact areas. The PCSS assembly further includes a PCSS lid forming a top end of the PCSS housing, wherein the PCSS lid includes a transparent lid window.

The PCSS assembly further includes an LS compartment. The LS compartment includes a LS housing, a triggering LS disposed at a bottom end of the LS housing, a LS housing window forming a top end of the LS housing, and a COE disposed above the triggering LS to form collimated light beams from the triggering LS. The PCSS compartment and the LS compartment are immediately adjacent to each other and at least the PCSS compartment is hermetically sealed, and the collimated light beams from the LS compartment pass through the COE, the LS housing window, the PCSS compartment window, and the FOE before striking the PCSS.

In a still further embodiment again, the PCSS assembly further includes a transmission line. The transmission line includes two transmission line conductive traces connected electrically to the PCSS contacts, a transmission line dielectric spacer including one or more layers, a transmission line ground plate, and an opening on the ground plate such that PCSS recombination light is capable of being observed through the opening, the PCSS lid window and the PCSS substrate.

In yet another additional embodiment, the one or more layers of transmission line dielectric spacer include an optically transparent material.

In a yet further additional embodiment, the one or more layers of transmission line dielectric spacer includes an optically opaque material, wherein each of the one or more layers of optically opaque transmission line dielectric spacer includes an opening aligned with the opening on the ground plate.

In yet another embodiment again, the PCSS assembly further includes an imaging device capable of observing PCSS current filament (recombination) light through the PCSS lid window and through the PCSS substrate.

In a yet further embodiment again, the imaging device is capable of observing PCSS current filament (recombination) light through an opening on at least one layer of an optically opaque transmission line dielectric spacer, at least one layer of optically transparent transmission line dielectric spacer, the PCSS lid window and the PCSS substrate.

Additional embodiments and features are set forth in part in the description that follows, and in part will become apparent to those skilled in the art upon examination of the specification or may be learned by the practice of the invention. A further understanding of the nature and advantages of the present invention may be realized by reference to the remaining portions of the specification and the drawings, which forms a part of this disclosure.

### BRIEF DESCRIPTION OF THE DRAWINGS

The description and claims will be more fully understood with reference to the following figures and data graphs, which are presented as exemplary embodiments of the invention and should not be construed as a complete recitation of the scope of the invention.
FIG. 1 illustrates a multi-compartmented photoconductive semiconductor switch (PCSS) assembly with embedded light source presented in a partially dismounted view in accordance with an embodiment of the invention.
FIG. 2 illustrates a connection scheme to connect a PCSS assembly to a transmission line in accordance with an embodiment of the invention.
FIG. 3 illustrates a PCSS lid with PCSS lid shrouds and flexible PCSS pushers in accordance with an embodiment of the invention.
FIG. 4 illustrates a PCSS internal lid frame in accordance with an embodiment of the invention.
FIG. 5 illustrates a PCSS internal lid attachment in accordance with an embodiment of the invention.
FIG. 6 illustrates an array of PCSS switch assemblies in accordance with an embodiment of the invention.
FIG. 7 illustrates an optical scheme with collimated beams in accordance with an embodiment of the invention.
FIG. 8 illustrates an optical scheme with slightly diverging beams which is less sensitive to misalignment in accordance with an embodiment of the invention.
FIG. 9A illustrates a PCSS and dashed light pattern projected on its surface by a spherical lens array in accordance with an embodiment of the invention.
FIG. 9B illustrates a PCSS surface with an illuminating pattern projected by a cylindrical lens array in accordance with an embodiment of the invention.
FIG. 9C illustrates current filaments at the PCSS surface triggered by the light lines displayed in FIGs. 9A and 9B in accordance with an embodiment of the invention.
FIG. 10 illustrates an electrical connection of the switch assembly in accordance with an embodiment of the invention.

### DETAILED DESCRIPTION

The following description sets forth exemplary aspects of the present disclosure. It should be recognized, however, that such description is not intended as a limitation on the scope of the present disclosure. Rather, the description also encompasses combinations and modifications to those exemplary aspects described herein.

A photoconductive semiconductor switch (PCSS) is a device consisting of a photoconductive substrate and conductive contacts fabricated on the surface of the substrate and separated by a gap. When an electrical potential difference is applied between the PCSS contacts, but the switch is not exposed to illumination, the substrate has a low electrical conductance, and it holds off a high voltage. However, when the switch is illuminated by light, free charge carriers are generated in the photoconductive substrate causing the resistance to rapidly drop and electric current to flow between the contacts through the substrate. These properties of the PCSS can enable high-voltage and high-current switching with a fast rise time or slew rate.

In the early days of PCSS research, PCSS devices were used only in linear modes where every photon absorbed by the photoconductive substrate was generating not more than one pair of free charge carriers (electrons and holes). Since the current flow is defined by the number of particles in conductance band accelerated by the applied voltage, the maximal current value linearly depended on the total optical energy incident on the surface of the PCSS. In this mode, achieving high current levels of the order of 1000 A (1 kA) required optical pulses of high energy which can only be obtained from powerful and bulky solid-state laser systems, making the system large and difficult to operate.

For example, to discharge a 100 kV voltage through a 50-Ohm load (when the PCSS on-resistance drops to approximately 1 Ohm) an optical pulse of around 50 mJ of energy would be needed. The discovery of a high-gain mode (also known as nonlinear, lock-on, or avalanche) in a PCSS comprised of gallium arsenide (GaAs) dramatically reduced the optical energy required to trigger the switch and achieve a high current. When the voltage or electric field strength exceeds the lock-on threshold (4-6 kV/cm for GaAs) each absorbed photon is capable of producing a large number of charge carriers (on the order of 10⁵) due to the avalanche effect.

Achieving PCSS longevity, i.e. the ability to survive many triggering cycles while conducting high current can represent an additional challenge. When the PCSS surface is illuminated by a uniform or Gaussian beam to initiate the triggering, a current path represents an unstructured stochastic discharge similar to a lightning bolt. The regions where current density is specifically high and especially the locations adjacent to the PCSS contacts where it is more concentrated initially (so-called current crowding), easily develop damaged areas and the PCSS lifespan rarely exceeds more than a few thousand shots for currents exceeding 100 A.

It was shown that splitting the charge flow into several paths (filaments) and limiting the current to 20-30 A per filament for a short pulse of 10-20 ns width can dramatically increase the longevity of GaAs PCSS up to greater than 10⁶ shots. Different methods were suggested to realize the current sharing. The first method was the structuring of a wide (uniform) beam or central part of a Gaussian beam focused onto the PCSS surface in the shape of narrow parallel lines. This could be achieved with such tools as a cylindrical lens stack, a glass micro lens array, a plastic micro lens array, glass rods, or simply by masking the surface of the switches with an opaque layer of slot apertures.

The second method was to initially use narrow light sources and arrange them into a periodic line pattern. These light sources were either placed close to the PCSS surface, or the light sources were mounted at a distance and then used an optical system to focus them onto the switch surface. Examples of this approach include the systems with stacked, edge-emitting semiconductor lasers and arrays of vertical-cavity surface-emitting lasers (VCSELs) with round apertures. A third method was current sharing with no structured light illumination but via the channels of modulated conductivity through the introduction of lattice defect damage in GaAs by high energy ion implantation.

While the concept of integrating a PCSS assembly and a light source together has been suggested, previous disclosures failed to describe any of the improvements and/or modifications that are necessary to achieve a compact PCSS switching device capable of handling high current and high voltage with a fast rise time (slew rate), a substantially improved lifespan, simplified methods of alignment, providing for the easy replacement of crucial parts as they wear out, and achieving a low maintenance device.

Systems and methods in accordance with many embodiments of the invention provide an integrated PCSS assembly with a light source having high current via a structured light source with no need to tailor or modulate additional PCSS assembly properties, which can simplify the PCSS assembly fabrication process. PCSS assemblies in accordance with various embodiments of the invention comprise a multi-compartment structure with an embedded light source that triggers the switch. PCSS assemblies may include three distinguishable parts including but not limited to: 1) a light source (LS) compartment; 2) an optical inspection compartment; and/or 3) a PCSS compartment. The multi-compartment arrangement can help to separate high voltage circuitry on the PCSS side from the electrical connection of the triggering LS, thereby protecting it from a possible breakdown and electromagnetic interference (EMI). In several embodiments, using a hermetically sealed PCSS compartment allows for an increase of the PCSS hold-off voltage when filled with a dielectric liquid or gas (a fluid). In some embodiments, the PCSS assembly may only use the LS compartment and the PCSS compartment and eliminate the optical inspection compartment if the PCSS assembly needs to be as compact as possible.

In many embodiments, the triggering LS includes a set of emitters (which may be a VCSEL array) spatially arranged in the form of periodic lines. The optical radiation from the set of emitters can be projected onto a PCSS surface and initiate a series of straight current filaments. In a number of embodiments, the multiple current paths result in high current density and a high total current through the PCSS which it can conduct without damage, thereby achieving better longevity in terms of the number of trigger cycles. The projection of the triggering LS onto the PCSS surface can be embodied by two optical schemes.

In several embodiments, a collimating optical element (COE) is used to collimate in one or two planes the beams generated by each light emitter. The suppressed divergence of the collimated rays can allow for increasing the distance between the high voltage PCSS part and thereby insulating the LS circuit. In the PCSS compartment, a focusing optical element (FOE) focuses the light onto the PCSS surface creating a periodic narrow line pattern that can induce current filaments when a voltage is applied between the PCSS contacts.

In a number of embodiments, the COE creates not perfectly collimated but weakly divergent beams. They are also focused by the FOE onto the PCSS surface. This scheme can be more robust against a misalignment of the LS compartment relative to the PCSS compartment. The optical inspection compartment can be placed between the LS compartment and PCSS compartment to reflect a small part of the LS radiation and most of the current filament emission enabling the possibility for an easy setup and performance control during the switch operation.

PCSS assemblies in accordance with various embodiments of the invention utilize a VCSEL array as a triggering LS together with the compact optical scheme, which can result in miniaturization and simplification of the switching of high voltage and high current with a PCSS and removes the need of a bulky and expensive solid-state laser system usually utilized for triggering purposes.

PCSS assemblies in accordance with several embodiments of the invention include non-trivial solutions to mount a PCSS in the PCSS compartment. These solutions may include the PCSS compartment contacts incorporating a precise spacer for the alignment of the FOE and the PCSS. The PCSS lid may be equipped with PCSS lid shrouds and flexible PCSS pushers. These features may simplify the assembling of the switch unit, providing an easy way for PCSS replacement, and allowing for minimization of the switch assembly dimensions.

In many embodiments, the small size factor is beneficial for stacking multiple PCSS units together to multiply the current handling capability and for integration into low impedance (transmission line) circuits where fast rise time (high current slew rate) can be achieved. PCSS assemblies in accordance with various embodiments of the invention embody a hard-to-achieve combination of a compact triggering LS, high-voltage insulation, optical transparency, mechanical precision and stability fitted together into a small multi-compartment package.

### Multi-Compartment PCSS Assembly

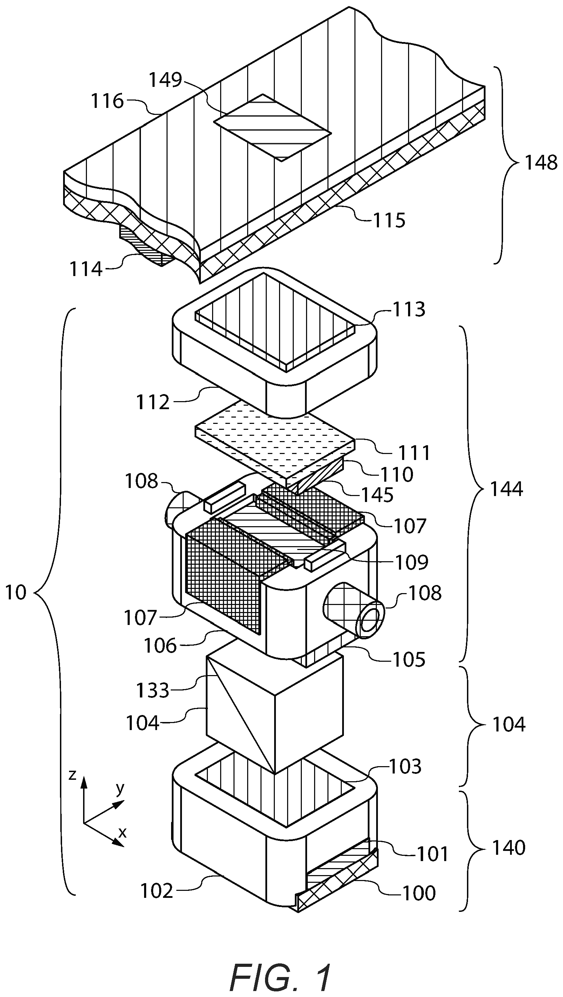

The following description and accompanying figures illustrate various aspects of PCSS assemblies in accordance with embodiments of the invention. A multi-compartmented PCSS assembly with an embedded LS in accordance with an embodiment of the invention is illustrated in FIG. 1. Referring to FIG. 1, the PCSS assembly 10 is shown in an exploded view to provide a better view of the principal components. The PCSS assembly 10 comprises several compartments and components arranged in a vertical stack configuration along the Z-axis.

At the bottom of the assembly, the LS compartment 140 includes a triggering LS 100, which may be a VCSEL array, positioned at the bottom end of a LS housing 102. A COE 101, such as a microlens array, is disposed above the triggering LS 100 to transform divergent light into collimated light beams. An LS housing window 103 is disposed on the LS housing 102 opposite to the triggering LS 100 and may be transparent for collimated light beams. The LS housing window 103 may function as dust protection and may also include an anti-reflective coating. In some embodiments, the LS housing window may have a transparent conductive coating, such as indium tin oxide (ITO), if the LS housing is intended to be used as EMI protection for the LS circuit.

Above the LS compartment 140, an optical inspection compartment 104 is positioned between the LS compartment 140 and a PCSS compartment 144. The optical inspection compartment 104 includes a dichroic mirror 133 configured to transmit collimated light beams at the wavelength of the triggering LS 100 while reflecting a portion of light from the PCSS 110 for inspection purposes.

The PCSS compartment 144 further includes a PCSS housing window 105 forming the bottom end of a PCSS housing 106. The PCSS housing 106 accommodates a set of PCSS compartment contacts 107 that partially form opposite sidewalls and provide electrical connection between an external high voltage source and the PCSS 110. Two fluid connectors 108 are attached to the PCSS housing 106 for injection, extraction, and circulation of dielectric fluid. The fluid connectors 108 may be located on any surface of the PCSS housing 106 including the PCSS compartment contacts 107 and the PCSS lid 112. In one scenario, two fluid connectors 108 may be attached to threaded throughholes into the interior of the PCSS compartment 144. Alternatively, the two fluid connectors 108 may be fabricated as extruded parts of the PCSS housing 106, PCSS compartment contacts 107, or PCSS lid 112. An FOE 109 is disposed within the PCSS housing 106 and is shown as being coupled to the PCSS compartment contacts 107 or to the PCSS housing 106 itself. The FOE 109 focuses the collimated light beams onto a PCSS surface 145 of the PCSS 110 as narrow lines that may be solid, dotted or dashed to trigger PCSS current filaments. An example of the FOE may be a microlens array. The PCSS 110 is shown as being placed adjacent to the FOE 109 with the PCSS 110 in its focus, and may be coupled to a PCSS support substrate 111 for mechanical integrity. A PCSS lid 112 forms the top end of the PCSS housing 106 and includes a PCSS lid window 113 for inspection of the PCSS 110 condition.

At the top of the assembly, a transmission line 148 is connected to the PCSS compartment 144. The transmission line 148 includes a transmission line conductive trace 114, a transmission line dielectric spacer 115, and a transmission line ground plate 116. A transmission line opening 149 is provided in the transmission line ground plate 116 to allow observation of PCSS current filament recombination light through the PCSS lid window 113.

In many embodiments, the triggering LS may be a VCSEL array with a preferred aperture geometry and spatial arrangement of emitters, including but not limited to dot-shaped and/or rectangular dash-shaped VCSELs that form a periodic line pattern. The VCSEL array chip may be placed on a top face of a substrate, such as a printed circuit board (PCB) and it may emit upwards along direction Z in FIG. 1. The triggering LS may be electrically connected to metal contacts printed on the PCB and the metal contacts may be brought to locations, for example, a bottom face of the PCB that is convenient for the connection to an external LS driver.

In a number of embodiments, the collimating optical element, such as a microlens array, transforms divergent light generated by the triggering LS into collimated or nearly collimated (weakly divergent) light beams. Collimation can increase the distance between the triggering LS and the PCSS, thereby protecting the triggering LS and the PCB, including the external LS driver, from the high voltage on the PCSS side of the PCSS assembly, and electromagnetic interference (EMI) which can occur during the fast rise of PCSS current in the PCSS assembly.

In various embodiments, the triggering LS and the COE are mounted to a LS housing which may be made either from insulating (dielectric) or conductive materials. A conductive enclosure for the LS housing may serve as EMI protection of the triggering LS. The components described above constitute a first main compartment of the PCSS assembly and will be referred to collectively as the LS compartment. The LS compartment may be hermetically sealed and filled with a medium. The medium may be, for example, a dielectric medium such as a liquid or gas.

In several embodiments, the optical inspection compartment transmits a substantial portion of the collimated light beams towards the PCSS. The optical inspection compartment may also reflect radiation coming from PCSS current filaments (recombination light) which may be further observed with imaging devices including but not limited to a camera (not shown). In addition, the optical inspection compartment may be used to inspect the condition of the triggering LS by reflecting a small part of the collimated light beams (optical energy) to the opposite side as will be described below. This enables a user to observe and evaluate the quality of the triggering LS without the need for disconnecting the LS compartment from the PCSS assembly.

In many embodiments, the PCSS housing window may be transparent to the collimated light beams and may also have an anti-reflective coating. The PCSS housing window may be affixed to a PCSS housing which may be comprised of a dielectric material. For example, the dielectric material may be a plastic or a ceramic material capable of holding-off or being resistant to a high voltage, or hold-off voltage.

In several embodiments, the PCSS housing further includes two conductive PCSS compartment contacts that are also mounted to the PCSS housing. The function of the PCSS compartment contacts may be to provide an electrical connection between an external high voltage source and the PCSS surface of the PCSS. PCSS compartment contacts in accordance with several embodiments of the invention extend partially towards each other from opposite sidewalls of the PCSS housing but are electrically isolated from each other, with a gap between them to allow light beams to reach the PCSS surface.

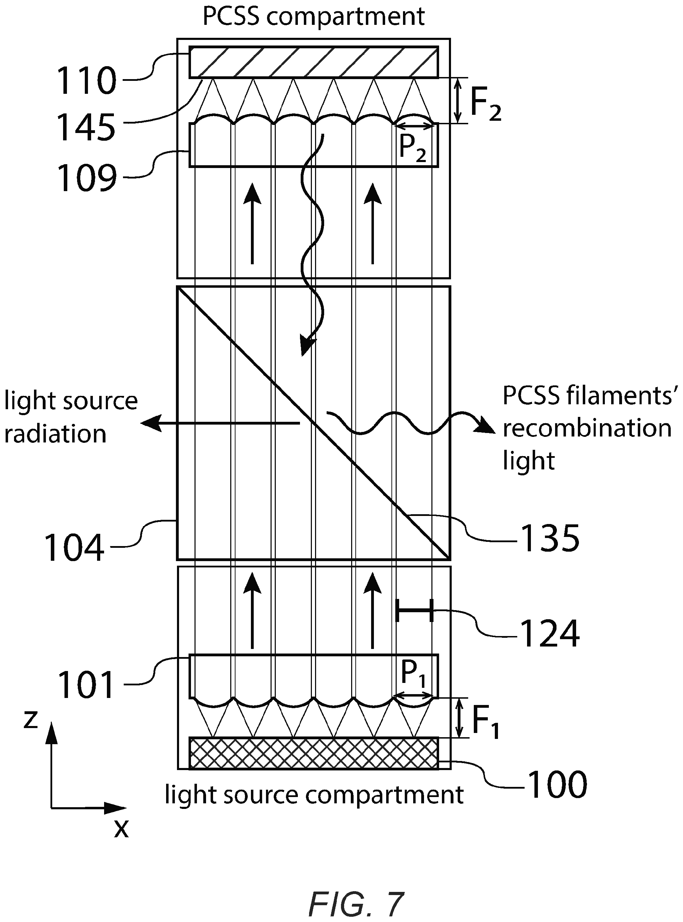

In a number of embodiments, FOEs may be microlens arrays. The PCSS is shown as being placed adjacent to the FOE with the PCSS in its focus. The PCSS may include a PCSS substrate with two intermediate contact areas fabricated on the surface and conductive PCSS contacts fabricated on top of the intermediate contact areas. The PCSS contacts are conductive (usually metallized) areas of the PCSS that make contact with the PCSS compartment contacts. The PCSS contacts may face corresponding PCSS compartment contacts but a PCSS contact gap between the PCSS contacts may be smaller than the distance between the PCSS compartment contacts such that the PCSS surface adjacent to the PCSS contacts is unobstructed to receive the collimated light beams (shown in FIG. 7), in order to initiate PCSS current filaments with the lowest possible optical energy and prevent their merging.

In various embodiments, the PCSS is typically manufactured from a semiconductor crystal which is fragile, which may then be coupled to a PCSS support substrate for additional mechanical integrity and robustness against physical shock and stress. The PCSS support substrate may be made of an insulating material to hold-off high voltage (the hold-off voltage) that is applied to the PCSS contacts and it is not necessary for it to match the size of the PCSS.

There are several methods to make an electrical connection between the PCSS contacts and PCSS compartment contacts. One approach is to mechanically press the PCSS (or the PCSS together with the PCSS support substrate) against the PCSS compartment contacts such that a good physical contact is established. A soft gold plating of the PCSS compartment contacts may help in creating a good electrical connection. Electrical connections may also be facilitated by incorporating conductive traces into the PCSS support substrate such as a co-fired ceramic or glass substrate with metal contacts. PCSS contacts may be connected to the PCSS support substrate conductive traces via gold wire or ribbon bonding. The conductive traces may then be connected to the PCSS compartment contacts by any convenient means such as mechanically, by soldering, by wire bonding, etc.

PCSS housings in accordance with many embodiments of the invention are sealed with the PCSS lid after the PCSS is disposed in a focal plane of the FOE. The PCSS lid may be fabricated from a dielectric such as a plastic or ceramic, and it may also have an optically transparent PCSS lid window to allow inspection of the condition of the PCSS, and a level and quality of the dielectric fluid, and PCSS current filaments (recombination light), which can be observed with an imaging device through the PCSS substrate, when the PCSS support substrate is transparent or absent.

In a number of embodiments, to achieve hold-off voltages higher than the breakdown of air for the PCSS contact gap, the PCSS compartment may be sealed hermetically and the dielectric fluid, such as Fluorinert^{™}, or a dielectric gas such as sulfur hexafluoride SF₆, may be injected through the fluid connectors to fill up the space around the PCSS and between the PCSS compartment contacts inside the PCSS housing. Alternatively, the space around the PCSS may be filled with a transparent solid dielectric (for example optical adhesive or transparent polymer) which will increase the PCSS hold-off voltage. The FOE also may be glued to the PCSS. This arrangement can provide an exceptional mechanical robustness but at sacrifice of PCSS longevity, which will not receive the circulation fluid in this case.

In various embodiments, the PCSS lid may be attached by a permanent adhesive such as an epoxy to provide the desired hermetic sealing. However, it may be more beneficial to make the PCSS lid removable and use a non-permanent seal such as a removable adhesive such as a silicone-based sealant, or an elastic gasket and a mechanical connection. For example, the PCSS lid may be screwed to the PCSS housing or to the PCSS compartment contacts. A removable PCSS lid provides the advantage of being able to replace the PCSS in case of damage, and to reuse the most expensive parts of the PCSS assembly, such as the triggering LS and PCSS compartment contacts with a new PCSS.

In several embodiments, dielectric fluid may be circulated through the PCSS compartment by a pump system to prevent a residue on the PCSS surface caused by PCSS current filament interaction with the dielectric fluid and also from the redeposition of metal particles extracted or evaporated from the PCSS contacts under a high current. The PCSS housing, PCSS compartment contacts, FOE, and PCSS lid may be structured with something such as walls and channels to provide a uniform and laminar flow of the dielectric fluid along the current conducting surface of the PCSS.

Although specific PCSS assemblies are described above with reference to FIG. 1, any of a variety of multi-compartment configurations may be utilized as appropriate to the requirements of specific applications in accordance with various embodiments of the invention. The number and arrangement of compartments, optical elements, and electrical connections may vary depending on the specific implementation.

### Transmission Line Connection

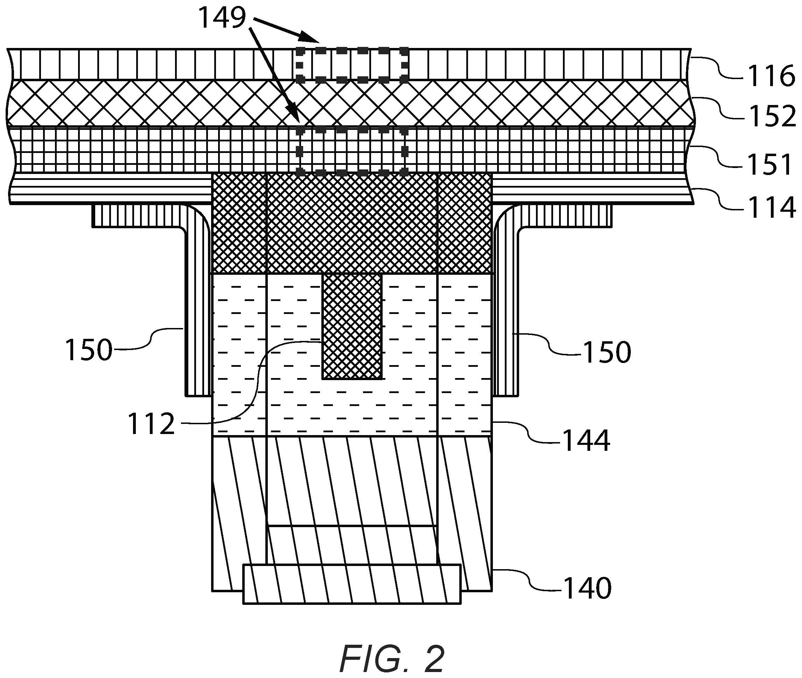

Taking advantage of the short rise time of the current within the PCSS, the PCSS compartment may be connected to a transmission line. A connection scheme to connect a PCSS assembly to a transmission line in accordance with an embodiment of the invention is illustrated in FIG. 2. Referring to FIG. 2, the cross-sectional view shows the integration of a PCSS assembly with a transmission line 148, depicting the spatial arrangement and interconnection of various components. The PCSS assembly includes an LS compartment 140 positioned at the bottom portion of the assembly and a PCSS compartment 144 disposed above the LS compartment 140. The PCSS lid 112 forms the top end of the PCSS compartment 144.

The transmission line structure is positioned above the PCSS compartment 144 and includes several layers. The transmission line conductive trace 114 is connected to the PCSS compartment via contact corners 150, which are disposed on opposite sides of the assembly and provide electrical connection between the PCSS compartment contacts and the transmission line conductive trace 114. Above the transmission line conductive trace 114, a transmission line dielectric spacer is shown comprising multiple layers. A dielectric optically opaque layer 151 is positioned adjacent to the transmission line conductive trace 114, and a dielectric optically transparent layer 152 is disposed above the dielectric optically opaque layer 151. The transmission line ground plate 116 is positioned at the top of the assembly above the dielectric optically transparent layer 152.

A transmission line opening 149 is formed in the transmission line ground plate 116 and the dielectric optically opaque layer 151. This opening 149 is aligned with the PCSS lid 112 and permits observation of PCSS current filament recombination light through the transparent dielectric layer 152 and the PCSS lid window when the PCSS assembly is in operation.

In various embodiments, PCSS compartments may connect to a transmission line to take advantage of the short rise time of the current within the PCSS. Transmission lines in accordance with a variety of embodiments of the invention include a transmission line conductive trace which has a gap opposite to the PCSS lid, a transmission line dielectric spacer, and a transmission line ground plate.

In several embodiments, the dielectric spacer can be a single layer optically opaque (for example FR4) or transparent (for example acrylic) material, or can be a multilayer, for example the combination of FR4 and polyimide film, which in contrast to acrylic are thermally stable to allow soldering of conductive traces directly on them. In certain embodiments, transmission line dielectric spacers include two layers of material. The first layer may be a dielectric optically opaque layer, which can provide mechanical stability and separation between the conductive trace and ground plate, and the second layer may be a dielectric optically transparent layer to provide dielectric strength to hold off the high voltage, for example a polyimide film.

In many embodiments, PCSS filaments may be directly observed through the PCSS lid window when the PCSS assembly is connected to a transmission line. Optical transparency may be required in the spectral band of the PCSS current filaments light. The transmission line may have an opening (observation window) opposite the PCSS in the transmission line ground plate and the dielectric optically opaque layer. In this geometry, PCSS current filaments (recombination light) may be directly visible with an imaging device through the transmission opening, transparent dielectric layer, PCSS lid window and the PCSS substrate.

In a number of embodiments, when the transmission line window size is properly selected, the opening does not affect the transmission line impedance and therefore does not impact the PCSS current risetime. In some embodiments, transmission line windows are 12 mm in width and 6 mm in length on ground plates that are 25 mm in width. The multilayer transmission line spacer can be beneficial here. In case of a combination of an FR4 and a polyimide film, the thicker FR4 provides mechanical stability to the transmission line and requires separation to maintain its impedance, but it can still have an opening to observe the PCSS filaments. The thin polyimide film can remain intact, since it is transparent to the PCSS recombination light, and it will provide enough dielectric strength to hold off the voltage between the conductive traces and the ground plate of the transmission line.

In various embodiments, the transmission line may be a part of an external circuit, or a piece of the transmission line may be part of the PCSS compartment. Together the LS compartment, optical inspection compartment, and PCSS compartment compose the multi-compartment PCSS assembly. The different compartments may be attached to each other or to a base plate providing mechanical stability and maintaining their relative positions and orientation for reliable PCSS triggering.

Although specific transmission line connections are described above with reference to FIG. 2, any of a variety of transmission line configurations may be utilized as appropriate to the requirements of specific applications in accordance with various embodiments of the invention. The number of dielectric layers, the materials used, and the specific dimensions may vary depending on the specific implementation.

### PCSS Lid Configurations

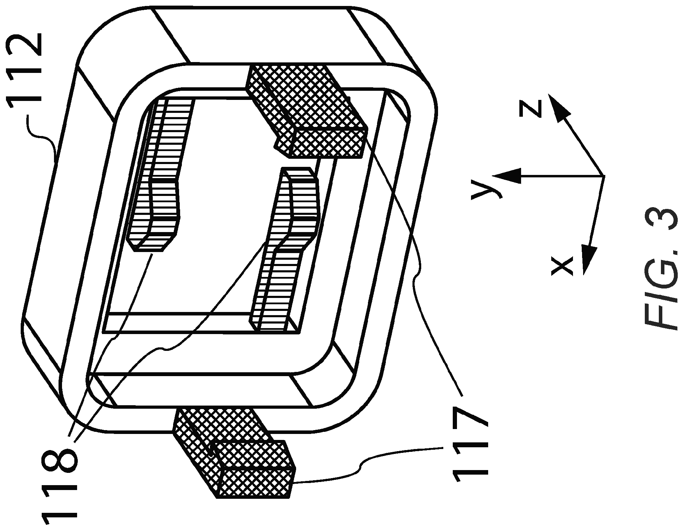

As previously described above, it may be beneficial to be able to easily replace a damaged PCSS. In addition, it may be useful to minimize the size of the PCSS assembly. These goals may be realized with the help of features implemented in a design of the PCSS lid. A PCSS lid in accordance with an embodiment of the invention is illustrated in FIG. 3. Referring to FIG. 3, the PCSS lid 112 is shown in an isometric view. The PCSS lid 112 includes PCSS lid shrouds 117 positioned on opposite sides of the lid structure. The PCSS lid shrouds 117 may be fabricated as an integral part of the PCSS lid 112 and are configured to lock the PCSS lid 112 onto the PCSS housing. The PCSS lid 112 further includes flexible PCSS pushers 118 extending from an interior portion of the lid structure. The flexible PCSS pushers 118 are configured to press against the PCSS or the PCSS support substrate when the flexible PCSS pushers 118 are slightly deflected, thereby pushing the PCSS contacts against the PCSS compartment contacts.

PCSS lid shrouds in accordance with various embodiments of the invention simplify the attachment and detachment of the PCSS lid and access to the PCSS. In addition, PCSS lid shrouds can reduce the need for extra material around the PCSS lid, the PCSS housing or the PCSS compartment contacts, which might be required if the PCSS lid were attached by connectors such as, for example screws. The extra space and materials would provide a safety margin so that the screws from outside would not penetrate into the space filled with a dielectric fluid to thereby prevent breaking the hermetic seal. Furthermore, a longer distance in the air would be needed between metal screw heads to avoid a high voltage breakdown.

An advantage of the flexible PCSS pushers in comparison to a screw-based mounting method is the shorter time that is required for the insertion and mounting of the PCSS with the PCSS pushers than with the screws. Additionally, a pressure limit of the PCSS pushers is set by the material properties of the PCSS pushers and thereby helps to protect the PCSS, which otherwise could be cracked by an overtightened screw.

Although specific PCSS lid configurations are described above with reference to FIG. 3, any of a variety of lid designs may be utilized as appropriate to the requirements of specific applications in accordance with various embodiments of the invention.

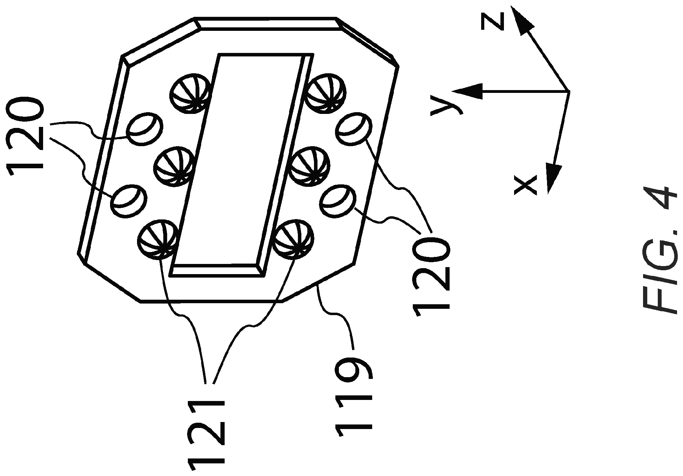

A PCSS internal lid frame in accordance with an embodiment of the invention is illustrated in FIG. 4. Referring to FIG. 4, the PCSS internal lid frame 119 is shown in an isometric view. The PCSS internal lid frame 119 includes multiple PCSS frame mounting screw holes 120 positioned around the perimeter of the frame. The PCSS internal lid frame 119 further includes several pressure point extrusions 121 arranged around the central opening. The pressure point extrusions 121 have a semi-spherical shape and serve as pressure points for the PCSS or PCSS support substrate.

In various embodiments, PCSS lids have two pressure points on the PCSS which are located against the middle of the PCSS contacts. In some cases, more robust PCSS mounting is advisable, for example, to enhance mechanical robustness against vibrations or when the dielectric fluid flow needs to be increased to withstand higher pulse repetition frequency (PRF). For this purpose, an internal PCSS lid frame may be used. The PCSS internal lid frame may be made of a slightly flexible material in which throughholes for PCSS frame mounting screws are made.

Although specific PCSS internal lid frames are described above with reference to FIG. 4, any of a variety of internal lid frame designs may be utilized as appropriate to the requirements of specific applications in accordance with various embodiments of the invention.

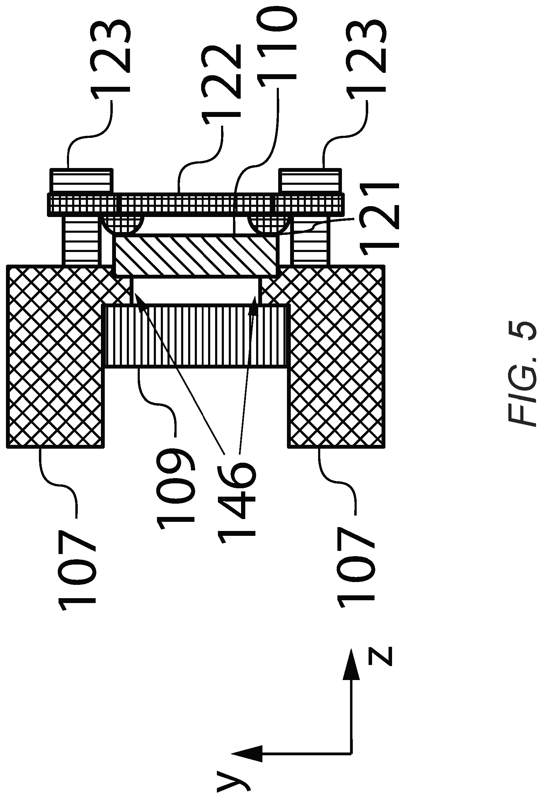

A PCSS internal lid attachment in accordance with an embodiment of the invention is illustrated in FIG. 5. Referring to FIG. 5, the profile view shows the mounting arrangement for securing a PCSS 110 within the PCSS housing using a PCSS internal lid frame 122. Two PCSS compartment contacts 107 are positioned on opposite sides of the assembly. An FOE 109 is disposed below the PCSS 110 and is aligned parallel with the PCSS 110. A precise optical spacer 146 is positioned between the FOE 109 and the PCSS 110 to maintain a specific distance between these components. The PCSS internal lid frame 122 is disposed on top of the PCSS 110 and includes pressure point extrusions 121 positioned to push the PCSS 110 against the PCSS compartment contacts 107. The PCSS internal lid frame 122 is secured by screws 123 which attach to the PCSS compartment contacts 107.

In various embodiments, the PCSS internal lid frame is disposed on top of the PCSS or the PCSS support substrate and the pressure points are positioned behind the middle and both ends of the two PCSS contacts to push them against the PCSS compartment contacts. The PCSS internal lid frame may be tightened by the screws which go through the PCSS frame mounting screw holes and then attach to PCSS compartment contacts where tapped holes may be made for this purpose.

The PCSS internal lid frame may be fabricated from a slightly flexible material to allow all the pressure point extrusions to maintain contact with the PCSS surface. After the PCSS internal lid frame is attached, the PCSS lid with PCSS lid shrouds shown in FIG. 3 may be used to close and seal the PCSS compartment. In this case, the flexible PCSS pushers are not necessary for the PCSS lid since the PCSS internal lid frame provides the mounting pressure. Since the PCSS lid shrouds, the flexible PCSS pushers, and the PCSS internal lid frame require some flexibility while remaining dielectric, ceramic may not be a suitable material for these components. These components may instead be fabricated from different types of flexible plastic.

Although specific PCSS internal lid attachments are described above with reference to FIG. 5, any of a variety of mounting arrangements may be utilized as appropriate to the requirements of specific applications in accordance with various embodiments of the invention.

### Stacked PCSS Assemblies

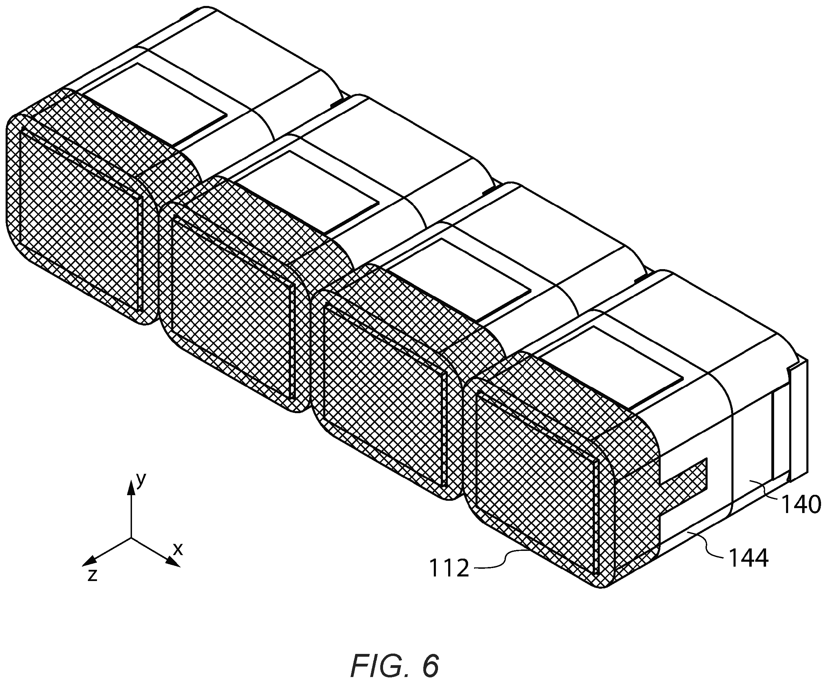

The PCSS lid geometry can minimize the size of the PCSS assembly and enable multiple units of the PCSS assembly to be stacked in a row with a minimal spacing between them. An array of PCSS switch assemblies in accordance with an embodiment of the invention is illustrated in FIG. 6. Referring to FIG. 6, the isometric view shows multiple PCSS assemblies positioned adjacent to one another in a row formation along the x-axis direction. Each PCSS assembly in the array includes an LS compartment 140 and a PCSS compartment 144. The PCSS lid 112 of each assembly is indicated by a cross-hatch pattern on the upper surfaces of the PCSS compartments 144. In this figure only the LS compartment and PCSS compartments are included in each of the PCSS assemblies.

Connecting the PCSS assemblies to a high voltage circuit or power source in parallel allows for achieving not only larger current values but also a high current density. The PCSS lid shrouds can reduce the thickness of the PCSS lid and the PCSS housing and can minimize the gaps between the closest current filaments at adjacent PCSS assemblies.

In several embodiments, the stack of the PCSS assemblies is connected to a low impedance transmission line to achieve a high current and a fast rise time. The small gap between the multiple PCSS assemblies conducting the current helps by reducing the inductance of the circuit. An example of a useful application of the stacked configuration is a series of integrated Blumlein antenna devices meant for the generation of high-power microwaves. In this case, the high current density helps to achieve higher energy density of the radiated signal and the small size of the PCSS assemblies assists to achieve higher frequencies of the generated microwaves.

Although specific stacked PCSS assembly configurations are described above with reference to FIG. 6, any of a variety of array arrangements may be utilized as appropriate to the requirements of specific applications in accordance with various embodiments of the invention.

### Optical Schemes

PCSS assemblies in accordance with various embodiments of the invention may utilize different optical schemes to deliver light from the triggering LS to the PCSS surface. The projection of the triggering LS onto the PCSS surface can be performed in several ways. An optical scheme with collimated beams in accordance with an embodiment of the invention is illustrated in FIG. 7. Referring to FIG. 7, the optical scheme depicts the path of light from a triggering LS 100 through various optical components to a PCSS 110. A COE 101 is disposed above the triggering LS 100 and transforms divergent light generated by the triggering LS 100 into collimated light beams 124. The COE 101 is shown as a cylindrical lens array with a period P1 and is positioned at a focal distance F1 from the triggering LS 100.

An optical inspection compartment 104 is disposed between the LS compartment and a PCSS compartment. The optical inspection compartment 104 includes a reflecting layer 135 configured to transmit the collimated light beams 124 at the wavelength of the triggering LS 100 while reflecting a portion of light from the PCSS 110 for inspection purposes. An FOE 109 is positioned within the PCSS compartment above the optical inspection compartment 104. The FOE 109 is shown as a cylindrical lens array with a period P2 and focuses the collimated light beams 124 onto a PCSS surface 145 of the PCSS 110. The FOE 109 is located at a focal distance F2 from the PCSS surface 145. The paths of the collimated light beam are illustrated in Fig. 7 by solid lines.

Flat optical windows such as the LS housing window and the PCSS housing window may not substantially change the path of the collimated light beams. The triggering LS can emit radiation to initiate PCSS current filaments between the PCSS contacts. Examples of the triggering LS may include but should not be considered as limited to VCSEL arrays, laser diodes, arrays of laser diodes, etc.

In several embodiments, individual emitters in a VCSEL array may be of different shapes such as round, square, or rectangular. To form a filament series for current sharing on the PCSS the emitters of the triggering LS may be arranged into a line pattern repeating with a period P1 in the direction along the PCSS contacts, shown as being perpendicular to the contact gap which corresponds to the X axis in FIG. 7 and FIG. 1.

In various embodiments, triggering LSs using VCSEL arrays can provide a short light pulse rise time (less than 1 ns), to maintain PCSS current filament uniformity and to avoid merging. In general, the light pulse rise-time value may depend on many parameters, such as peak intensity reaching the PCSS surface, filament spacing P2, the size of the PCSS contact gap, the maximal voltage, PCSS current filaments at the PCSS, PCSS material, etc. If the triggering LS is generated by small emitters whose aperture size is comparable to their wavelength, the collimating light beams may start diverging quickly and may be collimated to reach the PCSS without a great loss of intensity.

In a number of embodiments, the collimating optical element may be placed next to the triggering LS to collimate or nearly collimate the diverging light beams of the triggering LS. The COE may be any optical element that performs the phase modulation, and possibly amplitude modulation, of the triggering LS. Examples of the COE may include but should not be considered as limited to cylindrical lens arrays (as shown in FIG. 7 with the cylinders' axes oriented along the lines of the triggering LS), spherical and anamorphic lens arrays, diffractive optical elements, metasurfaces, etc. The COE may have an anti-reflection optical coating. If the COE is a lens array, the numerical aperture (NA) of the lenses may be equal to greater than the NA of the triggering LS to collect all the light from every emitter.

Lens arrays in accordance with various embodiments of the invention are placed at their focal distance (F1) from the emitters to achieve a good collimation of light from the triggering LS. It is also possible that the COE may be directly attached or manufactured together with the triggering LS. The collimated light beams travel further to the optical inspection compartment which may be an optional component (as shown in FIG. 6). The main purpose of the optical inspection compartment is to reflect PCSS current filament (recombination) light from the PCSS. Thus, it may be optimized to have a maximal transmission for the wavelength of the triggering LS (the collimated light beams marked by straight arrows in FIG. 7).

Since the triggering LS is powerful, even less than 0.1% of residual reflection from the optical inspection compartment may be sufficient to observe its light on an imaging device if a quality check of the emitters is required. The triggering LS may be more efficient when its wavelength is shorter than the bandgap of the PCSS semiconductor material, but the recombination light wavelength is usually near the bandgap, thus it is possible to use a dichroic mirror or a similar spectrally selective reflector for the optical inspection compartment. Other examples of suitable components may be a beam splitting cube or plate, a beam sampler, etc.

In many embodiments, the collimated light beams enter the PCSS compartment which may be filled with a dielectric fluid to increase hold-off voltage between the PCSS contacts. In the case of a dielectric fluid, the medium inside the PCSS compartment may have a different refractive index than around COE remaining in the air. The collimated light beams can propagate further towards the focusing optical element which is meant to focus the collimated light beams tightly onto the PCSS surface into narrow regions to trigger the PCSS current filaments in the shape of straight lines separated by the period distance P2.

In a number of embodiments, the FOE may be represented by the same wide range of amplitude and phase modulating optical elements as the COE and, in addition, it may be an array of axicons for Bessel beam generation or pure amplitude (opaque) masks with the required aperture pattern placed close to the PCSS surface. As shown in FIG. 7, the FOE may be a cylindrical lens array with the period P2 located at the focal distance F2 from the PCSS surface. In general, P2 may not be equal to P1 and F2 may not be equal to F1 because different focal distances are generally unavoidable, if the same COE and FOE are used and the PCSS compartment is filled with a dielectric fluid, but the COE is in the air. After the FOE the collimated light beams impinge on the PCSS surface and trigger the PCSS current filaments between its PCSS contacts.

In various embodiments, recombination light generated from the PCSS current filaments propagates from the PCSS surface back, as marked by waving arrows in FIG. 7. However, as the PCSS current filaments generate an incoherent undirected light, the light from one PCSS current filament may fall onto several lenses of the FOE, and only some parts of it will become collimated after passing the FOE and will propagate back towards the optical inspection compartment. At the optical inspection compartment, the recombination light can be diverted by the reflecting layer and can be observed on an imaging device to monitor the quality of the PCSS current filament. Without additional optical elements before the imaging device the observation can mostly give information about the number of PCSS current filaments that are triggered and their average brightness, since it is not a direct image of the PCSS surface but only of the collimated beams from the PCSS current filaments. However, additional optical elements, for example, a lens array similar to FOE placed before the imaging device can be used to obtain the PCSS current filaments' image at the PCSS surface.

In several embodiments, when the COE and FOE have equal periods where P1 = P2 for a given LS such as a VCSEL array, the highest peak intensity in the FOE focus at the PCSS surface may be achieved. However, a perfect relative alignment of the COE and FOE may be required, when one collimated light beam from one lens of the COE falls entirely into the aperture of one lens of the FOE, as illustrated in FIG. 7. This may not be easy to achieve, as the PCSS housing may not be able to be machined with a high precision from a metal, but it has to be made from a dielectric to insulate the high voltage between its PCSS contacts. A shift along the X-direction by a half of the period P1 between the FOE and the COE may reduce the peak intensity in the focus at the PCSS by half.

Although specific optical schemes with collimated beams are described above with reference to FIG. 7, any of a variety of optical configurations may be utilized as appropriate to the requirements of specific applications in accordance with various embodiments of the invention.

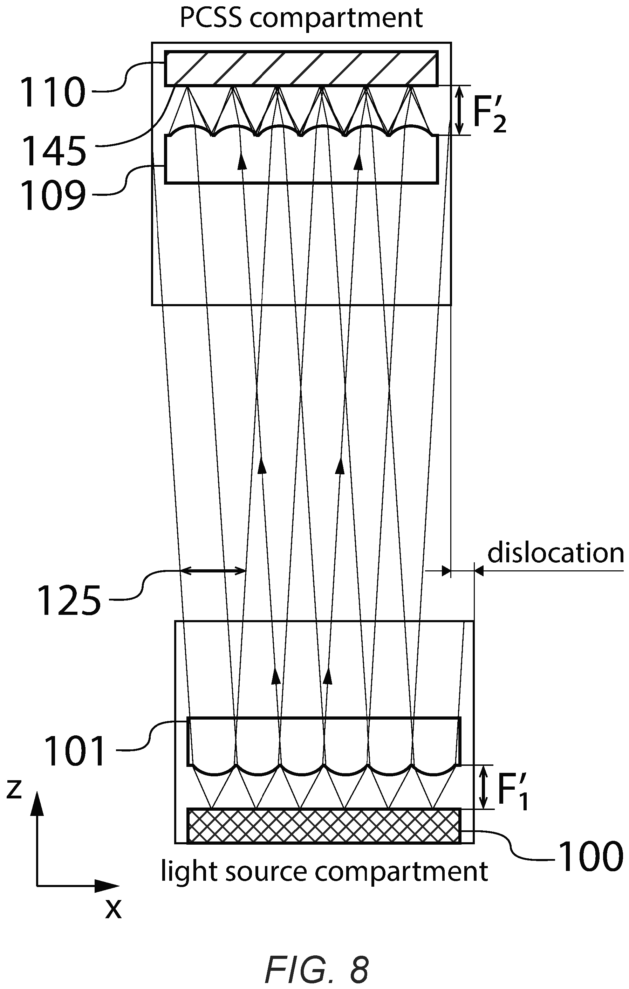

In various embodiments, the optical scheme may be configured to tolerate a misalignment between the COE and the FOE. An optical scheme with slightly diverging beams in accordance with an embodiment of the invention is illustrated in FIG. 8. Referring to FIG. 8, the optical scheme includes a triggering LS 100 disposed at a bottom portion of the assembly, a COE 101 positioned above the triggering LS 100, an FOE 109 positioned in an upper portion of the assembly, and a PCSS 110 disposed adjacent to the FOE 109. The PCSS 110 includes a PCSS surface 145 onto which light is focused. In this optical configuration, the COE 101 does not perfectly collimate the light from the triggering LS 100. Instead, the COE 101 produces light beams (slightly diverging) 125 that slowly diverge as they propagate upward toward the FOE 109.

The slightly diverging nature of the light beams 125 is achieved by positioning the triggering LS 100 at a distance F'1 from the COE 101 that deviates from the focal distance of the COE 101. Similarly, the FOE 109 is positioned at a distance F'2 from the PCSS surface 145 that may deviate from the focal distance of the FOE 109 to provide focusing onto the PCSS surface 145.

In various embodiments, this optical scheme may have an advantage of tolerating a misalignment between the COE and the FOE. In this configuration, the COE does not perfectly collimate the light beams and they slowly diverge, such that the light beam from one COE lens covers several lenses of the FOE. One lens of the FOE receives light beams from several lenses of the COE and when the light beams are focused onto the PCSS surface, their focal points are slightly shifted along the X-direction.

In several embodiments, peak intensity at every focal point is inversely proportional to the width of the light beam at the FOE if the COE is a cylindrical lens array, i.e. the light beam covering three lenses would have the peak intensity about three times lower than a light beam covering just one FOE lens. Nevertheless, the free-charge carriers generated by these separate focal points may combine, and the optical power radiated by a VCSEL array may be sufficient to initiate PCSS current filament triggering with a GaAs PCSS using this optical scheme.

In many embodiments, the distance (F'1) between the triggering LS and the COE may deviate from the focal distance F1 of the lens array to provide the slight divergence of beams. Similarly, the distance (F'2) between the FOE and the PCSS may deviate from the focal distance F2 of FOE to provide focusing onto PCSS surface. In a variety of embodiments, this optical scheme may be less sensitive to the shifts along the X-direction in between the LS compartment and PCSS compartment. Thus, it can simplify the alignment and improve mechanical stability.

In a number of embodiments, a precise distance between the COE and the triggering LS may be maintained to achieve beam collimation quality and triggering reliability. In many embodiments, a precise spacer may be inserted in between the two parts for this purpose. Alternatively, without a spacer, the components may be carefully aligned and then affixed to the triggering LS housing by, for example, an adhesive. A precise distance may also be provided between the FOE and the PCSS surface, which may also be achieved by using a precise spacer or mounting the FOE to the PCSS housing or PCSS compartment contacts by an adhesive. In addition, since the PCSS compartment contacts are made of a metal, it may be possible to fabricate a precise spacer right at the PCSS compartment contacts, as it is shown in FIG. 5 where the PCSS compartment contacts have a metal step which works as a spacer between the FOE and PCSS and the same metal step makes an electrical connection to the PCSS contacts.

### PCSS Current Filament Patterns

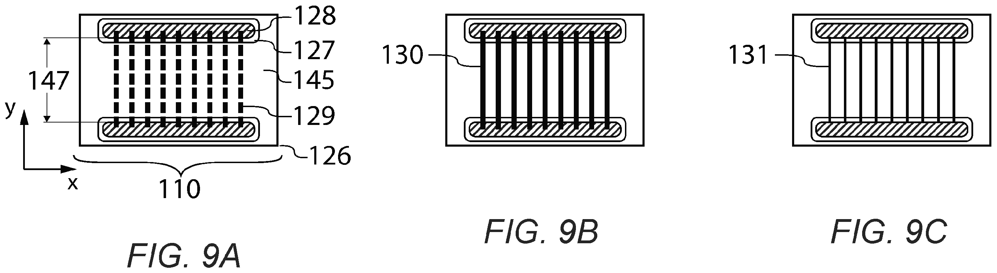

The main purpose of the optical schemes described above is to project the radiation from the triggering LS onto the PCSS surface while achieving a high peak intensity. PCSS configurations and light patterns in accordance with embodiments of the invention are illustrated in FIGs. 9A-9C. Referring to FIG. 9A, a PCSS 110 is shown with a dashed light pattern projected on its surface by a spherical lens array. The PCSS 110 comprises a PCSS substrate 126 where two intermediate contact areas 127 are fabricated on the surface. Two conductive PCSS contacts 128 are fabricated on top of the intermediate contact areas 127. The PCSS contacts 128 are separated by a PCSS contact gap 147. An image of triggering LS 129 is projected onto the PCSS surface 145 in a periodic dashed line pattern.

The same PCSS configuration is shown in FIG. 9B with an illuminating pattern projected by a cylindrical lens array. In this embodiment, continuous lines (light projection) 130 are projected onto the PCSS surface 145 rather than the dashed pattern shown in FIG. 9A. The continuous lines 130 extend across the PCSS contact gap 147 between the PCSS contacts 128 and intermediate contact areas 127.

Referring to FIG. 9C, PCSS current filaments 131 at the PCSS surface 145 are shown that are triggered by the light lines displayed in FIGs. 9A and 9B. The PCSS current filaments 131 form as parallel straight lines extending between the PCSS contacts 128 across the PCSS contact gap 147.

In various embodiments, the PCSS includes a PCSS substrate where two intermediate contact areas (for example, doped semiconductor regions) may be fabricated on the surface and then two conductive PCSS contacts may be fabricated on top of them. The semiconductor material may have additional coatings such as an antireflective optical layer. In many embodiments, PCSS current filaments (recombination light) may be observed through the PCSS substrate when the PCSS support substrate is transparent or absent.

In several embodiments, if the triggering LS is represented by a VCSEL array with a dash-line pattern and the COE and FOE are spherical lens arrays, then the image of the triggering LS will be directly projected to the PCSS surface. For the same VCSEL array, it is possible to use a cylindrical lens array as the COE and the FOE. In this case, the emitter's aperture size in the Y-direction is much larger compared to its wavelength and the collimated light beam diverges much slower along this axis than along X where the aperture size is small. A cylindrical lens array with axes oriented along the Y axis taken as the COE would collect and collimate the light in the X-plane, however the weak divergence along the Y-direction would make the light projection look like continuous lines as shown in FIG. 9B.

In many embodiments, areas adjacent to the PCSS contacts are illuminated. Each of the light patterns shown in FIGs. 9A and 9B should trigger a series of parallel straight line PCSS current filaments between the PCSS contacts as displayed in FIG. 9C. The PCSS current filaments can divide the current equally when the illumination pattern is highly uniform. The PCSS displayed is called a lateral PCSS, because both PCSS contacts are fabricated on the same surface and the PCSS current filaments are propagating along this interface. In many embodiments, PCSS assemblies may include PCSS types other than the lateral PCSS.

Although specific PCSS current filament patterns are described above with reference to FIGs. 9A-9C, any of a variety of light patterns and PCSS configurations may be utilized as appropriate to the requirements of specific applications in accordance with various embodiments of the invention.

### Electrical Operation

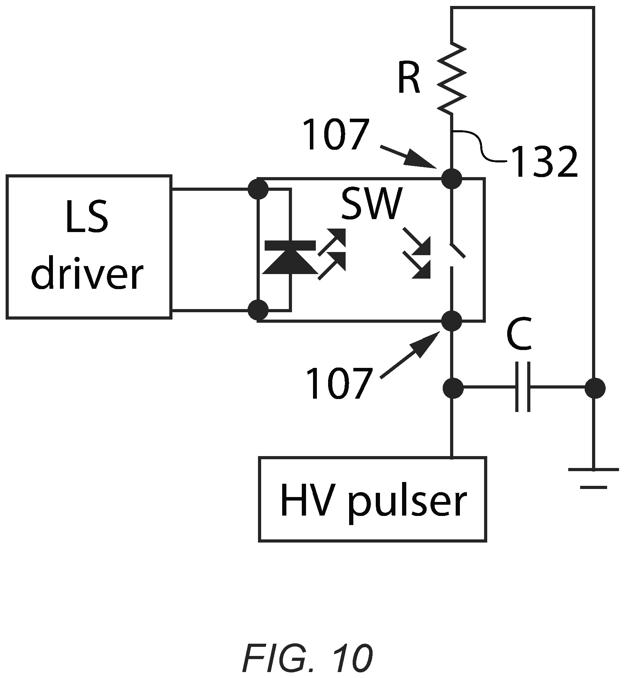

PCSS assemblies in accordance with a variety of embodiments of the invention described above may be connected to an external high voltage circuit for pulsed power applications. An electrical connection scheme of the switch assembly in accordance with an embodiment of the invention is illustrated in FIG. 10. Referring to FIG. 10, the circuit diagram shows how a PCSS assembly, represented as switch SW, interfaces with external circuitry for high-voltage pulsed power applications. The diagram features PCSS compartment contacts 107, a high voltage circuit 132, a resistor R, a capacitor C, a LS driver (LS driver), and a high voltage pulser (HV pulser). The capacitor C serves as a high voltage charge storage device and is connected to one of the PCSS compartment contacts 107. The resistor R functions as the load and is connected to another of the PCSS compartment contacts 107, with the load R then connected to ground.

In various embodiments, high voltage circuits can be connected to the switch unit by connecting a high voltage charge storage device such as a capacitor to one of the PCSS compartment contacts and the load to another PCSS compartment contact. The load can then be connected to ground. In a case when a transmission line is used and connected to the PCSS assembly, the charge may be stored in the transmission line directly instead of the capacitor.

In several embodiments, a high voltage pulse source (HV pulser) may be used to charge the capacitor rather than a DC source, limiting the high voltage on the PCSS to a time interval not longer than several microseconds. While the capacitor is charging, the PCSS can remain in a non-conductive state and the high voltage circuit is open. Once the capacitor is charged with the high voltage, a driving circuit connected to the triggering LS (LS driver) can generate an electric pulse.

In many embodiments, the pulse initiates a light flash that propagates towards the PCSS through the optical elements of the PCSS assembly and is finally focused onto the PCSS surface. When a critical number of photo-induced charge carriers are generated at the PCSS, they can trigger an avalanche of charges and form the PCSS current filaments. The high voltage circuit can be closed, and the charges can start flowing through the load. If a GaAs PCSS achieves the lock-on mode, then it can remain conducting until the voltage on the switch drops below the lock-on voltage level.

Although specific electrical connection schemes are described above with reference to FIG. 10, any of a variety of circuit configurations may be utilized as appropriate to the requirements of specific applications in accordance with various embodiments of the invention.

Although only a few example embodiments have been described in detail above, those skilled in the art will readily appreciate that many modifications are possible in the example embodiments without materially departing from this invention. Accordingly, all such modifications are intended to be included within the scope of this disclosure as defined in the following claims. It is the express intention of the applicant not to invoke 35 U.S.C. § 112, paragraph 6 for any limitations of any of the claims herein, except for those in which the claim expressly uses the words 'means for' together with an associated function.

Although specific methods of utilizing a multi-compartmented PCSS assembly with embedded light source are discussed above, many different methods can be implemented in accordance with many different embodiments of the invention. It is therefore to be understood that the present invention may be practiced in ways other than specifically described, without departing from the scope and spirit of the present invention. Thus, embodiments of the present invention should be considered in all respects as illustrative and not restrictive. Accordingly, the scope of the invention should be determined not by the embodiments illustrated, but by the appended claims and their equivalents.

## Claims

1. **A photoconductive semiconductor switch** (PCSS) assembly comprising:
a PCSS compartment comprising:
a PCSS housing;
a PCSS disposed within the PCSS housing;
a set of PCSS compartment contacts for providing power to the PCSS;
a PCSS compartment window forming a bottom end of the PCSS housing;
a PCSS lid forming a top end of the PCSS housing; and
a focusing optical element (FOE) disposed within the PCSS housing for focusing light beams onto the PCSS;
a light source (LS) compartment comprising:
an LS housing;
a triggering LS disposed at a bottom end of the LS housing;
an LS housing window forming a top end of the LS housing; and
a collimating optical element (COE) disposed above the triggering LS to form collimated light beams from the triggering LS;
wherein the PCSS compartment and the LS compartment are immediately adjacent to each other and at least the PCSS compartment is hermetically sealed; and
wherein the collimated light beams from the LS compartment pass through the COE, the LS housing window, the PCSS compartment window, and the FOE before striking the PCSS.

2. The PCSS assembly of claim 1, **wherein:**
the PCSS housing forms sidewalls;
the set of PCSS compartment contacts partially forms opposite sidewalls of the PCSS housing and is configured to provide an electrical connection between an external high voltage source and the PCSS, wherein the set of PCSS compartment contacts extends partially towards but are electrically isolated from each other;
the PCSS is disposed in contact with the set of PCSS compartment contacts and positioned across an upper portion of the PCSS housing;
the FOE is aligned parallel with and adjacent to the PCSS, and being disposed closer to the bottom end of the PCSS housing than the PCSS; and
wherein the LS is coupled to the PCSS and configured to induce photoconductivity in the PCSS to enable rapid switching.

3. The PCSS assembly according to any one of the preceding claims, **further comprising** an optical inspection compartment disposed between the PCSS compartment and the LS compartment,
wherein the optical inspection compartment comprises a dichroic mirror configured to transmit the collimated light beams of a wavelength of the triggering LS from the LS compartment to the PCSS compartment while reflecting a portion of light from the PCSS for inspection.

4. The PCSS assembly according to any one of the preceding claims, **wherein** the PCSS housing and the PCSS lid are made of a high-voltage insulation material configured to withstand and isolate high-power electrical discharges within the PCSS assembly.

5. The PCSS assembly according to any one of the preceding claims, **wherein** the PCSS compartment is filled with a dielectric fluid to increase hold-off voltage between the set of PCSS compartment contacts.

6. The PCSS assembly of claim 5, **further comprising** fluid connectors attached to the PCSS housing for injection, extraction, and circulation of the dielectric fluid.

7. The PCSS assembly according to any one of the preceding claims, **wherein** the PCSS lid comprises PCSS lid shrouds for attaching the PCSS lid to the PCSS housing and flexible PCSS pushers configured to press the PCSS against the set of PCSS compartment contacts.

8. The PCSS assembly according to any one of the preceding claims, **wherein** the FOE comprises a microlens array configured to focus the collimated light beams into a periodic line pattern on a surface of the PCSS.

9. The PCSS assembly according to any one of the preceding claims, **further comprising** a transmission line connected to the PCSS compartment.

10. The PCSS assembly of according to any one of the preceding claims, **wherein** the PCSS assembly is capable of being arranged in a stack configuration with one or more additional PCSS assemblies to increase current handling capability.

11. The PCSS assembly of according to any one of the preceding claims, **wherein** the triggering LS and the FOE are configured to project a periodic line pattern onto a surface of the PCSS to induce multiple current filaments, thereby enabling current sharing and increasing the total current handling capability of the PCSS.

12. The PCSS assembly of according to any one of the preceding claims, **wherein** the triggering LS comprises a vertical-cavity surface-emitting laser (VCSEL) array at a predetermined wavelength.

13. The PCSS assembly of according to any one of the preceding claims, **wherein:**
the COE is configured to transform light from the triggering LS into weakly divergent light beams,
wherein a distance between the triggering LS and the COE deviates from a focal distance of the COE to produce the weakly divergent light beams; and
the FOE is configured to focus the weakly divergent light beams onto a surface of the PCSS.

14. The PCSS assembly of according to any one of the preceding claims, **wherein** the set of PCSS compartment contacts comprises a precise spacer disposed between the FOE and the PCSS to maintain a precise distance between the FOE and PCSS.

15. The PCSS assembly of claim 14, **wherein** the precise spacer serves as conductive contact surfaces and provides an electrical connection to the set of PCSS compartment contacts.

16. The PCSS assembly of according to any one of the preceding claims, **wherein** the PCSS comprises a PCSS substrate, two intermediate contact areas fabricated on a surface of the PCSS substrate, and a set of conductive PCSS contacts fabricated on top of the intermediate contact areas.

17. The PCSS assembly of claim 1, wherein the PCSS lid **further comprises** a transparent PCSS lid window.

18. The PCSS assembly of claim 17, **further comprising** a transmission line, wherein the transmission line comprises:
two transmission line conductive traces connected electrically to the set of conductive PCSS contacts;
a transmission line dielectric spacer comprising one or more layers;
a transmission line ground plate; and
an opening on the ground plate such that PCSS recombination light is capable of being observed through the opening, the transparent PCSS lid window and the PCSS substrate.

19. The PCSS assembly of claim 18, **wherein** the one or more layers of transmission line dielectric spacer comprise an optically transparent material.

20. The PCSS assembly of claim 18 or 19, **wherein** the transmission line dielectric spacer comprises at least one layer of an optically opaque material and at least one layer of an optically transparent material, wherein each of the at least one layer of optically opaque transmission line dielectric spacer comprises an opening aligned with the opening on the ground plate.

21. The PCSS assembly according to any one of claim 17 to 20, **further comprising** an imaging device capable of observing PCSS current filament (recombination) light through the transparent PCSS lid window and through the PCSS substrate.
